**Europäisches Patentamt**

(19) **European Patent Office**

**Office européen des brevets**

(11) Publication number : **0 516 548 A2**

(12) # EUROPEAN PATENT APPLICATION

(21) Application number : **92401467.3**

(22) Date of filing : **27.05.92**

(51) Int. Cl.⁵ : **G11C 11/402**, G11C 11/404, G11C 11/406

(30) Priority : **28.05.91 KR 869491**
**12.06.91 KR 961491**

(43) Date of publication of application :
**02.12.92 Bulletin 92/49**

(84) Designated Contracting States :
**BE DE FR GB IT NL**

(71) Applicant : **Kim, Wonchan**
**Hanshin Apt. 217-712, Banpo-3-dong**
**Sucho-ku, Seoul (KR)**

(71) Applicant : **Lee, Hun-il**
**Taikyo Apt. 1-1007, Yoido-Dong**
**Yeongdeungpo-Ku, Seoul (KR)**

(72) Inventor : **Kim, Wonchan, Cabinet**
**Ballot-Schmit**
**7 rue Le Sueur**
**F-75116 Paris (FR)**

(74) Representative : **Schmit, Christian Norbert**
**Marie et al**
**Cabinet Ballot-Schmit 7, rue Le Sueur**
**F-75116 Paris (FR)**

(54) **A dynamic random access memory cell.**

(57) A DRAM cell and a method for memorizing data, which comprises a storage capacitor, a switching element for applying a bit line voltage/current to the storage capacitor during the time of writing cycle, a switching/amplifying element for amplifying and switching a reference voltage or an electric potential to the bit line. The method is characterized by the operation of switching/amplifying element which is controlled by an electric potential induced in the storage capacitor whereby the electric charge may not be lost during the read cycle.

FIG. 2

## BACKGROUND OF THE INVENTION

### 1. Field of the Invention

The present invention relates to dynamic random access memory (hereinafter "DRAM") cell and more particularly, to a DRAM cell comprising a storage capacitor, a switching element, and a switching/amplifying element, wherein the data stored in the storage capacitor can be read-out without destroying the electric charge held in the storage capacitor.

### 2. Description of the Prior Art

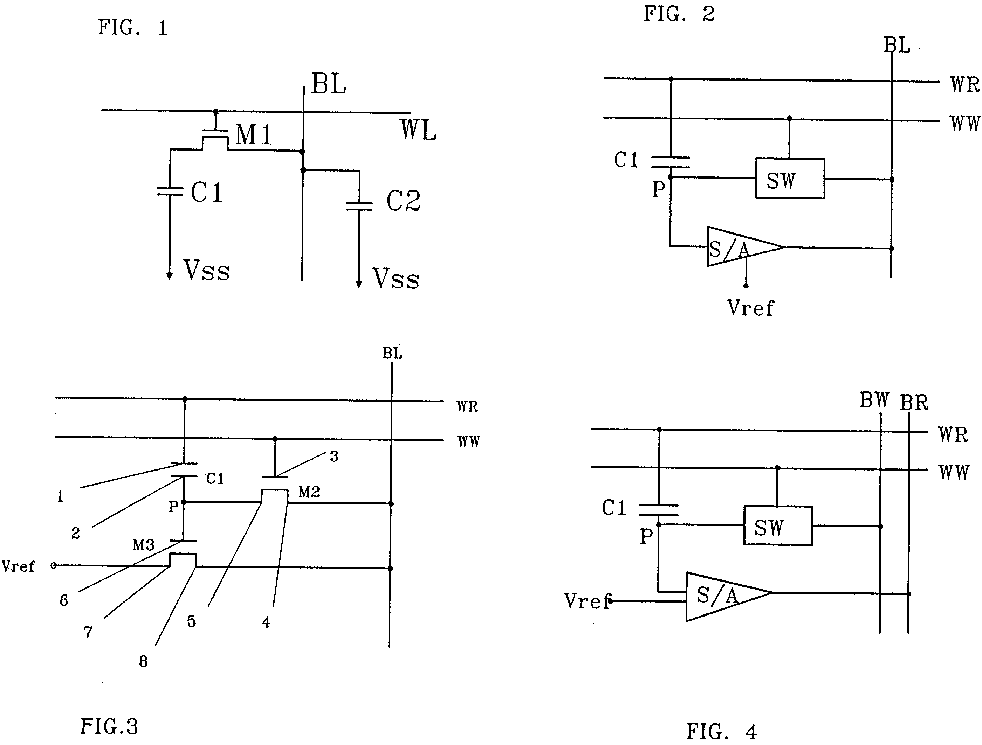

Various types of conventional DRAM cells including one access transistor and one storage capacitor are well known in the art as shown in Fig. 1.

In Fig. 1, M1 is an access (pass) transistor, C1 is a storage capacitor, C2 is a parasitic capacitor of a bit line, BL and WL are the bit line and a word line, respectively.

A write operation is performed by placing the data ("0" or "1") on the bit line BL and by applying a control voltage VA to a gate of a switching element to turn it on, thus electrically connecting the bit line BL to the storage capacitor C1. Then the storage capacitor C1 is charged to a voltage corresponding to "0" or "1" according to the bit line information. A read operation is done by precharging the bit line LB to an appropriate voltage level, for example, half value of the supply voltage, and again by applying a control voltage to the word line, thus enabling the stored charge to be shared with the bit line. The voltage of the bit line BL is increased or decreased a little according to the voltage of the storage cell C1, which implies the fundamental drawback of the conventional 1-transistor 1-capacitor DRAM cell. The charge which is initially stored in the cell during the write cycle must be shared with the bit line during the read operation, so the data stored in the cell is destroyed. Therefore, an additional write operation is necessary to restore the data in the cell after each read operation. The most serious problem of this 1-transistor 1-capacitor DRAM cell is how to find an optimal compromise of the ratio of the capacitance of the storage capacitor to that of the bit line. A lower bound is determined by the bit line capacitance. Usually, the bit line capacitance is much larger than the storage capacitance, so that the voltage change of the bit line BL determined by the ratio of the bit line capacitance to the storage capacitance is small. The ratio is restricted by the limitation of the input range of the sense amplifier and the requirements for the fast access time. And the bit line capacitance itself has a lower bound due to some factors such as the parasitic capacitances of the switching elements connected to the bit line. Therefore, there are fundamental limits on the storage capacitance and the area occupied by the storage capacitor.

## SUMMARY OF THE INVENTION

Accordingly, it is an object of the present invention to provide a DRAM cell of non-destructive readout mode and a method for storing and reading data, whereby the electric potential held in the storage capacitor may not be lost during a read cycle.

Another object of the present invention is to provide a DRAM which comprised a data stored in a storage capacitor which is used to drive the bit line instead of sharing its charge with the bit line wherein for this purpose, two devices are used; one in order to form an electric path from the bit line to the storage cell, and another one to drive the bit line according to the stored data without destroying it, and while the former element is solely for switching purpose, the second element acts as an amplifying element and/or as a switching element depending on its operation mode, so that a composite word, a switching/amplifying element, will be used for the latter one and the control node of the switching/amplifying element controls the operation thereof by electric field.

A further object of the present invention is to provide a DRAM cell which comprises a storage capacitor with two nodes, a switching element with a reference node, an output node, and a control node, a switching/amplifying element with a reference node, an output node, and a control node wherein one node of the storage capacitor is connected to the read-word line and the other node of it to the control node of the switching/amplifying element, the reference node of the switching/amplifying element is connected to a reference voltage line, the output node of the switching/amplifying element is connected to the bit line, the input node of the switching element is connected to the bit line, the output node of the switching element to the control node of the switching/amplifying element (the other node of said storage capacitor), and the control node of the switching element to the write-word line.

Still another object of the present invention is to provide a method for storing a data on the bit line to a storage capacitor and reading the stored data from the storage capacitor, comprising the steps of, storing the data on the bit line to charge the storage capacitor with a voltage on the bit line by turning on a switching element and by turning off the switching element so that the stored charge in the storage capacitor may not be lost, providing one node of the storage capacitor with a read voltage, switching/amplifying an electric potential induced on the other node of the storage capacitor to the bit line, the electric potential being the sum of the read voltage and an electric potential held in the storage capacitor, and/or simultaneously transferring a voltage/current to the bit line according to the electric potential through a path which is different from the path for storing the data on the bit line in the storage capacitor, reading the data on the bit line by sensing a voltage/current on the bit line, whereby the electric potential held in the storage capacitor may not be lost during the read cycle.

Yet another object of the present invention is to provide a non-destructive read-out DRAM cell with an operation scheme wherein a write operation is performed by storing the bit line voltage/current on the storage capacitor by turning on the switching element, whose control node is connected with the write-word line, a read operation is performed by sensing the change of the bit line voltage/current caused by the amount of the charge stored on the storage capacitor, and the control of the charge transfer from the reference node to the output node of the switching/amplifying element is done by the read-word line.

A further object of the present invention is to provide a non-destructive read-out DRAM cell which can be read and written with two levels of voltage/current, "0" and "1" and can be read and written with more than two levels of voltage/current.

Other objects and further scope of applicability of the present invention will become apparent from the detailed description given hereinafter. It should be understood, however, that the detailed description and specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS

The present invention will become more fully understood from the detailed description given hereinbelow and the accompanying drawing which are given by way of illustration only, and thus are not limitative of the present invention, and wherein :

Fig. 1 is a schematic equivalent circuit diagram of a conventional 1-transistor 1-capacitor DRAM cell ;
Fig. 2 is a block diagram of the DRAM cell of the present invention ;
Fig. 3 is a schematic equivalent circuit diagram of the present invention ; and
Fig. 4 is a block circuit of the DRAM cell of another embodiment of the present invention.

DESCRIPTION OF THE PREFERRED EMBODIMENTS

Referring now in detail to the drawings for the purpose of illustrating preferred embodiments of the present invention, the non-destructive read-out DRAM cell as shown in Fig. 2, 3 and 4, comprises a storage capacitor C1 with two nodes, a switching element SW with an input node, an output node, and control node, and a switching/amplifying element S/A with a reference node, an output node, and a control node. This cell incorporates a bit line BL, a read-word line WR, and a write-word line WW for read and write operation, respectively.

As shown in Fig. 2, one node of the storage capacitor C1 is connected to the read-word line WR and the other to the control node of the switching/amplifying element S/A. The reference node of the switching/amplifying element S/A is connected to a reference voltage line Vref, and the output node of the switching/amplifying element S/A is connected to the bit line BL. The input node of the switching element SW is connected to the bit line BL, the output node of the switching element SW is connected to the second node of the storage capacitor C1 and to the control node of the switching/amplifying element S/A. The control node of the switching element SW is connected to the write-word line WW.

A write operation is performed by applying the control voltage Vw to the write-word line WW and the control node of the switching element SW so that bit line voltage/current is stored on the storage capacitor C1.

A read operation is performed by applying a reference voltage to the reference voltage line Vref and by applying the control voltage Vr (read voltage) to the read-word line WR, so that the sum of the voltage of the read-word line and the voltage stored on the storage capacitor C1 is applied to the control node of the switching /amplifying element S/A. Two levels (the voltage levels corresponding to "0" to "1") or more than two levels of voltage/current data can be stored at the storage capacitor C1 during the write cycle, and the data in two levels or more than two levels can be read out during the read cycle.

Fig. 3 shows the equivalent circuit of the non-destructive read-out DRAM cell. The capacitor C1 is the storage capacitor with two nodes, a first node 1, and a second node 2. A transistor M2 is a switching element SW with a control node 3, an input node 4, and an output node 5. Either a pMOS transistor or an nMOS transistor which is embodied in semiconductor or placed on an insulator can be used for the switching element SW. The transistor M3 is a switching/amplifying element that can either be a pMOS transistor or an nMOS transistor with a reference node 7, a control node 6 and an output node 8.

The switching/amplifying characteristic between the node 7 and the node 8 of the switching/amplifying element S/A is controlled by the voltage difference of the control node 6 and the reference node 7 or by the voltage difference of the control node 6 and the output node 8. The control node 3 of the transistor M2 is connected to the write-word line WW, the input node 4 of the transistor M2 is connected to the bit line BL, and the output node 5 of the transistor M2 is connected to the second node 2 of the storage capacitor and to the control node 6 of the transistor M3. Nodes 2, 5, 6 are mutually connected and denoted as P. The node 7 of the transistor M3 is connected to the reference voltage line Vref and the node 8 of the transistor M3 is connected to the bit line BL. The first node 1 of the storage capacitor C1 is connected to the read-word line WR.

The write operation is performed by applying a control voltage Vw on the write-word line WW. Then the transistor M2 is turned on and the input node 4 and the output node 5 are electrically connected each other, so the data on the bit line BL, for example, "1" is written to the storage capacitor C1 in the form of an electric charge. During this write cycle, the voltage on the WR line can be either zero volt or another voltage, and the reference voltage Vref is held to a constant voltage. The write cycle is ended by turning off the write signal on the write-word line WW.

The read operation is performed by applying a control voltage Vr to the read-word line WR. Then the sum of the control voltage Vr and the voltage across the storage capacitor C1, which represents the data stored on the cell, is applied to the control node 6 of the switching/amplifying transistor M3. The charge transfer from the node 7 to the node 8 of the switching/amplifying transistor M3 is controlled by either the voltage difference of the node 6 and the node 8 according to the operation mode of the transistor M3. The read cycle, is completed by sensing the change of the voltage/current of the bit line. During this read cycle, the voltage on the write-word line WW is kept smaller than the threshold voltage of the transistor M2 so that the transistor M2 remains switched off. The reference voltage Vref can be held either to V1, the same value used during the write cycle, or to another voltage V2. For some applications the reference voltage Vref can be the same value as the ground voltage.

The circuit diagram of another embodiment of the present invention is shown in Fig. 4. The only difference of this circuit from that of Fig. 3 is that the bit line BL is separated into two bit line BW and BR. The BW is a write-bit line and the BR is a read-bit line.

The important feature of these operation modes is that the data initially stored on the storage capacitance is not destroyed and the read control voltage is applied to the control node of the switching/amplifying element S/A through the storage capacitor C1 during the read cycle, which makes a distinction to the conventional 1-transistor 1-capacitor DRAM cell. Applying more than two levels of voltage/current, for example, 4 levels or more on the bit line, it is possible to read and write multilevel voltage/current to represent more than one bit of data. This increases the data that can be stored on a memory cell.

Since the storage capacitor C1 is not directly coupled to the bit line BL or BR in Fig. 4 during the read operation and the voltage of the storage capacitor is used only to drive the control node of the switching/amplifying element S/A for read-out operation, the restriction on the size of the storage capacitance is not so severe as in the case of the conventional 1-transistor 1-capacitor DRAM cell. In summary, the storage capacitance need not be as large as that of the conventional DRAM cell, the cell area can be reduced, no additional write operation is required during the read cycle, and more than 2 voltage levels can be stored on the cell so the data stored can be substantially increased.

The invention being thus described, it will be obvious that the same may be varied in many ways. Such variations are not to be regarded as a departure from the spirit and scope of the invention, and all such modifications as would be obvious to one skilled in the art are intended to be included in the scope of the following claims.

## Claims

1. A DRAM cell for storing data to and reading data therefrom, which comprises :
   a storage capacitor,
   a switching element for connecting a bit line voltage to said storage capacitor during the time of writing cycle, and
   a switching/amplifying element connected to said storage capacitor and the bit line for switching/amplifying an electric potential induced on a node of said storage capacitor to the bit line, said electric potential being the sum of a read-word line voltage and an electric potential held in the storage capacitor, and/or transferring a voltage/current to the bit line according to said electric potential, whereby the electric charge may not be lost during the read cycle.

2. A DRAM cell comprising :
   a storage capacitor having two nodes,
   a switching element having an input node, an output node, and control node,
   a switching/amplifying element having a reference node, an output node, and a control node,
   one node of said storage capacitor being connected to the read-word line and the other node of said storage capacitor to the control node of said switching/amplifying element,
   said reference node of said switching/amplifying element being connected to a reference voltage line and the output node of said switching/amplifying element being connected to a bit line, and
   said input node of said switching element being connected to said bit line, the output node of said switching element being connected to the control node of said switching/amplifying element, and the control node of said switching element being connected to the write-word line, whereby the data stored in said storage capacitor through said switching element from the bit line can be read-out without destroying an electric charge of the storage capacitor by sensing a voltage/current occurred on the bit line through said switching/amplifying element.

3. The DRAM cell of claim 2, wherein said switching/amplifying element and said switching element are MIS transistors.

4. The DRAM cell of claim 2, wherein said switching/amplifying element and switching element are MOS transistors.

5. The DRAM cell of claim 2, wherein said bit line includes a write-bit line and a read-bit line.

6. A method for operating the DRAM cell of the claim 2, which comprises the steps of :
    storing the bit line voltage/current in the storage capacitor by turning on/off the switching element whose control node is connected with the write-word line,
    switching/amplifying a reference voltage from the reference node to the output node of the switching/amplifying element by providing the read-word line with a read voltage, and
    sensing the change of the bit line voltage/current caused by the amount of the charge stored in the storage capacitor.

7. The method of claim 6, wherein said reference voltage of the reference node of said switching/amplifying element is a fixed voltage.

8. The method of claim 7, wherein said reference voltage of the reference node of the switching/amplifying element is set to a fixed voltage during said storing step and is set to an another voltage during said switching/amplifying step.

9. The method of claim 7, wherein said reference voltage of the reference node of the switching/amplifying element is driven by the read-word line.

10. The method of claim 7, wherein said reference voltage of the reference node of the switching/amplifying element is varied according to the operation mode of the cell.

11. A method for storing a data on the bit line to a storage capacitor and reading the stored data from the storage capacitor, which comprises the steps of :
    storing the data on the bit line to charge the storage capacitor with a voltage on the bit line by turning on a switching element and turning off said switching element so that the stored charge in the storage capacitor may not be lost,
    providing on node of the storage capacitor with a read voltage,
    switching/amplifying an electric potential induced on the other node of the storage capacitor to the bit line, said electric potential being the sum of said read voltage and an electric potential held in the storage capacitor, and/or simultaneously transferring a voltage corresponding to the reference voltage to the bit line according to said electric potential through a path which is different from the path for storing the data on the bit line in the storage capacitor, and
    reading the data on the bit line by sensing a voltage/current change on the bit line, whereby the electric potential held in the storage capacitor may not be lost during the read cycle.

12. The method of claim 11, wherein the data on the bit line correspond with multiple levels of voltage/current.

13. The method of claim 11, wherein the data on the bit line correspond with two levels of voltage/current representing "0" and "1".

FIG. 1

FIG. 2

FIG. 3

FIG. 4